(19)

Europäisches
Patentamt
European
Patent Office
Office européen
des brevets

(11)     **EP 2 888 029 B1**

(12)                **EUROPEAN PATENT SPECIFICATION**

(45) Date of publication and mention
of the grant of the patent:
**07.11.2018  Bulletin 2018/45**

(21) Application number: **13742712.6**

(22) Date of filing: **25.07.2013**

(51) Int Cl.:
**B01D 67/00** *(2006.01)*        **H01J 37/32** *(2006.01)*
**B01D 69/10** *(2006.01)*

(86) International application number:
**PCT/GB2013/051991**

(87) International publication number:
**WO 2014/029963 (27.02.2014 Gazette 2014/09)**

(54) **METHOD OF TREATING A POROUS SUBSTRATE AND MANUFACTURE OF A MEMBRANE**

VERFAHREN ZUR BEHANDLUNG EINES PORÖSEN SUBSTRATES UND HERSTELLUNG EINER MEMBRAN

PROCÉDÉ DE TRAITEMENT DE SUBSTRAT POREUX ET FABRICATION D'UNE MEMBRANE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.08.2012  GB 201215098**

(43) Date of publication of application:
**01.07.2015  Bulletin 2015/27**

(73) Proprietor: **Fujifilm Manufacturing Europe BV
5047 TK Tilburg (NL)**

(72) Inventors:
• **STAROSTINE, Serguei
NL-5047 TK Tilburg (NL)**

• **DE VRIES, Hindrik
NL-5047 TK Tilburg (NL)**

(74) Representative: **Revell, Christopher et al
Intellectual Property Group
FUJIFILM Imaging Colorants Limited
6th Floor, Acresfield
8-10 Exchange Street,
Manchester M2 7HA (GB)**

(56) References cited:
**US-A- 6 118 218        US-A1- 2002 132 107
US-A1- 2011 210 063**

**Description**

This invention relates to a method of treating a substrate, comprising providing a treatment space between at least two opposing electrodes, and filling the treatment space with a gas composition.

Ion exchange membranes have wide applications including energy storage and conversion, electro-dialysis, separation of ionic species in environmental protection and clean production, and nano- or ultra-filtration. Most of ion exchange membranes are composed of functional polymers, in which the charged groups are chemically bonded to the polymer chains.

The charged groups are $-SO_3^-$, $-COO^-$, $-PO_3^{2-}$, $-PO_3H^-$, and $-C_6H_4O^-$, etc. for cat-ion exchange membranes and $-NH_3^+$, $-NRH_2^+$, $-NR_3^+$, $-PR_3^+$, and $-SR_2^+$, etc. for anion exchange membranes. Cat-ion exchange membranes contain negatively charged groups attached to the membrane backbone and allow the passage of cations but reject anions, while anion exchange membranes containing positively charged groups allow the passage of anions but reject cations.

In order to yield long lasting mechanical stable membranes it is advantageous to make the membrane having a porous stable polymer support as substrate and filling the pores with ion exchange material.

The use of hydrophobic, inert materials as the porous substrate will contribute to enhanced mechanical and chemical stability as hydrophobic materials have minimal swelling in aqueous media. Unfortunately, an inert hydrophobic base membrane is not typically compatible with ion exchange material, which is hydrophilic. Incompatibility between the materials of the base membrane and the ion exchange materials can cause membrane defects, such as holes in the membrane, because there is poor interfacial interaction between the base membrane and the ion exchange materials.

In the prior art, see for example the document US 2002/132107 A1, the use of plasma or corona treatments are disclosed, however, the methods described therein have the disadvantage that only the surface of the porous substrate is affected and not throughout the total porous substrate. As a result, there is a need for improved uniformly activated composite membrane materials compatible with the ion exchange material.

The present invention is defined by by the appended claims and seeks to provide a method of treating a porous substrate in order to allow manufacturing membranes in an efficient and cost-effective manner, and which solves the problems described above.

In an embodiment, a method according to the preamble above is provided, further comprising placing the substrate, which is a porous substrate in the treatment space, generating an atmospheric pressure glow (APG) discharge plasma between the at least two opposing electrodes, subjecting the porous substrate to the atmospheric pressure glow discharge plasma, thereby creating micro-pores uniformly throughout the porous substrate. The effect of the APG treatment is that the micro-pores are uniformly hydrophilic, allowing e.g. an easy impregnation step with (hydrophilic) ion exchange material.

The atmospheric pressure glow discharge plasma in the treatment space has a specific energy of 10 J/cm$^2$ or higher. This specific energy is advantageous because it can allow the particles in the plasma to penetrate sufficiently deep into the porous substrate.

In one embodiment, the porous substrate comprises a polymer support, e.g. of polyolefin, polyamide, polyester, polyether, acrylic or methacrylic polymers, polystyrene, polyurethane or cellulosic polymer or combinations thereof.

The method further comprises impregnating the substrate with ion exchange material. Thus, an ion exchange membrane is provided. The method may further comprise radiation curing of the porous substrate resulting in a ready to use membrane.

Heating the porous substrate to a temperature between 20 and 50°C is provided for in a further embodiment, resulting in a more efficient treatment of the porous substrate. Heating may be provided in a direct manner, or in an indirect manner, e.g. using heating of the electrodes.

In a further embodiment, the gas composition comprises a reactive gas and an inert or noble gas. For example, preferably the gas composition comprises 0.1 to 21 vol.% oxygen. This provides sufficient reactive particles in the APG plasma to treat the porous substrate entirely without damaging the substrate. In even further embodiments, the APG treatment is further enhanced by using an inert gas in the gas composition, e.g. nitrogen. Preferably the gas composition comprises 79 to 99.9 vol.% nitrogen, especially 95 to 99.9 vol.% nitrogen.

The micro-pores preferably are between 0.1 $\mu$m and 10 $\mu$m in size (i.e. average diameter) in a further embodiment (after the APG step). The porous substrate may have a porosity between 25 and 95%. The porosity of the substrate is defined as the percentage of the volume of all the pores in the substrate with respect to the whole volume of the substrate, including the pores.

The porosity values may be obtained by performing the following equation:

$$\text{porosity (\%)} = \{1 - \{ BW/(\text{thickness} \times p)\}\} \times 100\%$$

wherein:

BW is the weight of the porous substrate in g/m$^2$;
thickness is the average thickness of the porous substrate in $\mu$m; and
P is the density of the porous substrate in g/cm$^3$.

In successfully tested exemplary embodiments, substrates were used having a thickness of 60 $\mu$m or less, e.g. 25$\mu$m.

In a further aspect, the present invention relates to the use of a membrane comprising a substrate obtained by one of the present invention method embodiments. Such membranes can e.g. be used in energy storage and energy conversion, electro-dialysis, separation of ionic species e.g. in environmental protection and clean production, and nano- or ultra-filtration.

**Short description of drawings**

The present invention will be explained in further detail hereinafter based on a number of exemplary embodiments with reference to the drawings, wherein:

Fig 1 is a schematic view of the atmospheric pressure glow discharge plasma according to an embodiment of the present invention;
Fig. 2a shows a schematic detail view of an electrode structure of the plasma generation apparatus according to an embodiment of the present invention;
Fig. 2b shows a schematic view in more detail of a further embodiment of the electrode structure;
Fig. 3a shows a top view SEM image of an untreated Solupor™ 10P05A substrate;
Fig. 3b shows a top-side SEM image of a plasma treated Solupor™ 10P05A substrate according to an embodiment of the present invention;
Fig. 3c shows a bottom-side SEM image of a plasma treated Solupor™ 10P05A substrate according to an embodiment of the present invention;
Fig. 4a shows a reference example of a cross-cut of a membrane of the present invention;
Fig. 4b shows a cross-cut of a membrane according to an embodiment of the present invention;
Fig. 5 is a schematic overview of an alternative plasma apparatus according to an embodiment of the present invention.

**Detailed description of exemplary embodiments**

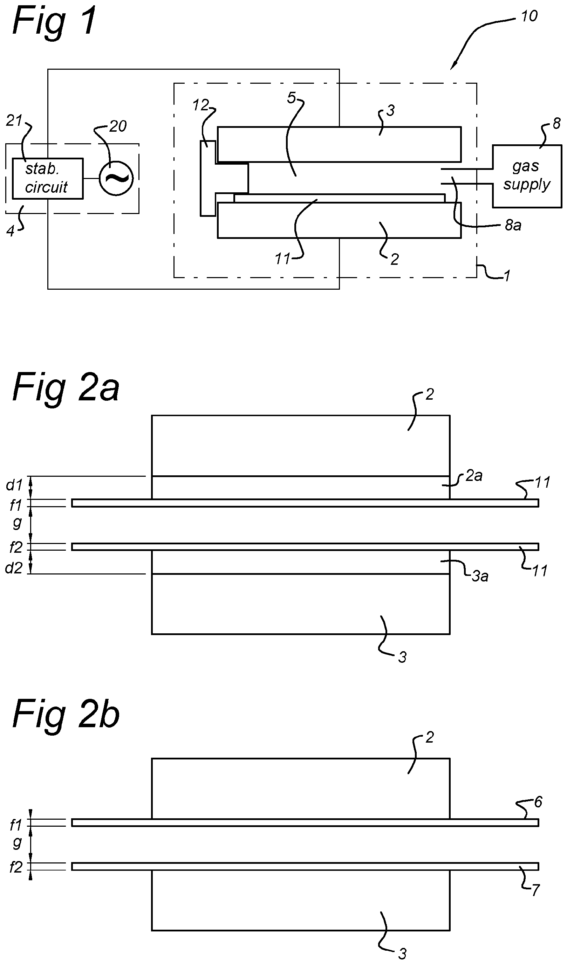

Fig. 1 shows a schematic view of an embodiment of a plasma treatment apparatus 10 in which the present invention may be applied. A treatment space 5, which may be a treatment space within an enclosure 1, or a treatment space 5 with an open structure, comprises two electrodes 2, 3. In general the electrodes 2, 3 are provided with a dielectric barrier in order to be able to generate and sustain a glow discharge plasma at atmospheric pressure in the treatment space (Atmospheric Pressure Glow discharge plasma, or APG plasma). Alternatively, a plurality of electrodes 2, 3 is provided. The electrodes 2, 3 are connected to a power supply 4, which is arranged to provide electrical power to the electrodes 2, 3 for generating the glow discharge plasma under an atmospheric pressure in the treatment space 5. As indicated in the embodiments of Fig. 1 the power supply 4 comprises an AC power source 20 connected to a stabilisation circuit 21.

The plasma treatment apparatus 10 is arranged to provide a uniform APG plasma, as opposed to other types of plasma, which are non-uniform (e.g. a corona discharge, or other types of filamentary discharges).

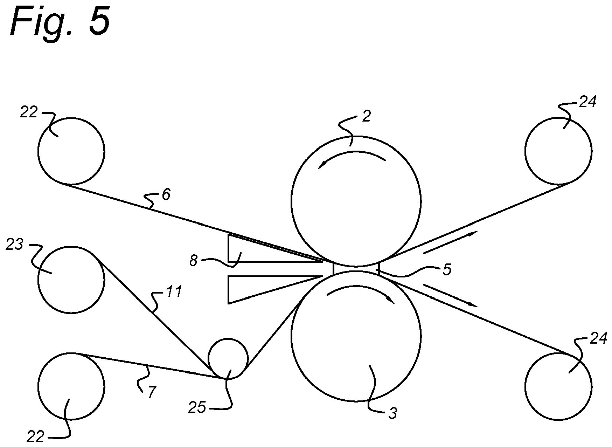

Fig. 1 shows a variant wherein one porous substrate 11 is treated. However, other treatments are possible like for example shown in Fig. 2a, where two porous substrates 11 are treated simultaneously, or in the example of Fig. 5, where one substrate 11 is treated while being supported by a substrate 7 acting as carrier.

In the treatment space 5, a combination of gasses is introduced from a gas supply device 8. The gas supply device 8 may be provided with storage, supply and mixing components as known to the skilled person. As shown in Fig. 1 a gas supply inlet may be provided to direct the gasses to the treatment space 5.

Further a side tab 12 may be used to close off the treatment space 5 on one side as is shown in Fig. 1 however the other side may be closed too which is not shown here.

The plasma treatment apparatus 10 is used according to the present invention embodiments, to treat at least one porous substrate 11 in order to make it suited for use in e.g. an ion exchange membrane, e.g. by filling the pores with ion exchange materials.

The composite membrane then includes a porous base substrate or base membrane 11, which has a plurality of pores. In one embodiment, the base substrate 11 has a three-dimensional matrix or lattice type structure with a plurality of nodes interconnected by a plurality of fibrils. The interconnections between the nodes and fibrils define the pores in the base membrane, which are open spaces or voids. The surfaces of the nodes and fibrils define numerous interconnecting pores that extend completely through the membrane.

The pore sizes in the base membrane 11 may be any size. In one embodiment, the average pore size of the pores in the base membrane is micro-porous. In another embodiment, the average pore size is in the range of about 0.01 $\mu$m to about 10 $\mu$m, and in another embodiment, the average pore size is in the range of about 0.1 $\mu$m to about 5.0 $\mu$m.

Porosity of the porous substrate 11, may be in the range from 25 to 95%. The porosity of the porous substrate 11, is defined as the percentage of the volume of all the pores in the substrate with respect to the whole volume of the substrate.

The base membrane 11 may be any material or blend of materials that is suitable for forming a base membrane with an open pore structure. In one embodiment, the base membrane material includes, but is not limited to, polyolefin, polyamide, polyester, polyether, acrylic and methacrylic polymers, polystyrene, polyurethane and cellulosic polymer and combinations thereof.

In an embodiment, the porous substrate are hydrophobic porous membranes made from hydrophobic materials like polyethylene (PE), polypropylene (PP), poly(vinylidene-difluoride) (PVDF), polytrifluorochloroethylene (PTFCE), polytetrafluoroethylene (PTFE), and polysulfone (PS).

In an exemplary embodiment, the base substrate is a microporous polyethylene film from Lydall from the Solupor™ series like for example Solupor™ 3P07A, 5P09A,7P03A, 7P07C, 10P05A, 14P01E, 16P05A and 16P10A. Solupor™ materials are produced by extrusion of a solvent together with a solution comprising a mixture of UHMW and HMW polyethylene, followed by drying the resulting tape and biaxial stretching of the tape, resulting in a micro-porous membrane. This process is described in more detail in EP 504,954 which is hereby incorporated by reference. The Solupor™ materials comprises UHMW polyethylene, and a portion of lower molecular weight polyethylene. The material is bi-axially stretched and has a porosity that can be varied between 45-95%. Depending on the needs, the porosity of the Solupor™ material can be adjusted by controlling the preparation parameters, such as the stretching factor to increase porosity and calendaring to reduce porosity. The person skilled in the art knows what techniques are available to control the porosity and he can easily determine which technique is most suitable for the situation. In addition, EP 0,504,954 describes some of those techniques. Solupor™ materials are commercially available in a range of porosities.

In one embodiment, the base substrate 11 has a thickness of 60 $\mu$m. In another embodiment, the base substrate or base membrane 11, has a thickness of about 25 $\mu$m or more.

The gases used in the plasma treatment apparatus 10 may vary depending on the intended application. The gasses can be selected for example from noble gases like argon and the like, an inert gas like nitrogen, and reactive gases like oxygen, hydrogen, carbon(di)oxide, nitrogen-oxide combinations of these reactive gases and inert or noble gases.

Both electrodes 2, 3 may have the same configuration being flat orientated (as seen in the embodiments of Fig. 2a/b) or both being roll-electrodes as can be seen in the embodiments of Fig. 5. Also different configurations may be applied using a flat and a roll-electrode opposing each other.

In the embodiment depicted in Fig. 5, a roll-electrode 2, 3 is e.g. implemented as a pair of cylinder shaped electrodes 2, 3, mounted to allow rotation in operation using e.g. a mounting shaft or bearings. The roll-electrodes 2, 3 may be freely rotating, or may be driven at a certain angular speed, e.g. using well known controller and drive units. The gas supply device 8 directs a suitable gas composition into the treatment space 5 interposed between the rotating electrodes 2, 3.

In the embodiment shown, three substrates 6, 7, 11 are provided to the treatment space 5 simultaneously by rotating supply drums 22, 23. Substrates 7 and 11 may be first laminated using lamination roller 25, which allows the top substrate 11 and other substrate 6 to be treated simultaneously in the treatment space 5 and subjected to an atmospheric pressure glow discharge plasma, thereby creating micro-pores throughout the top substrate 11 and substrate 6. After treatment, the substrate 6, and laminated substrate 7, 11 are received on storage drums 24. The embodiment in Fig. 5 is particularly suitable for mass production of the composite membranes as the substrates 6, 7, 11 are supplied in a continuous manner.

In a further embodiment three substrates are provided to the treatment space 5 simultaneously as shown in Fig. 5 without a lamination step and substrate 7 is just acting as carrier substrate for the porous substrate 11. Substrates 6, 7 are brought in contact with the respective electrodes 2, 3 and act as a dielectric barrier (as explained with reference to Fig. 2b). Both substrates 7, 11 are received after the atmospheric pressure glow discharge plasma treatment on a receiving roll 24. After an unwinding step (which is not shown here) the substrates 7, 11 may be separated from each other. This embodiment is particularly suitable to control the dielectric barrier and thereby creating a stable and uniform plasma.

Fig. 2a and 2b show two embodiments of a part of the plasma treatment apparatus 10 with different electrode configurations. Both electrodes 2, 3 can be provided with a dielectric barrier layer 2a, 3a as shown in the embodiment of Fig. 2a. The dielectric layer 2a on the first electrode 2 has a thickness of d1 (mm), and the dielectric layer 3a on the second electrode 3 has a thickness of d2 (mm). In operation, the total dielectric distance d of the electrode configuration also includes the thickness of the (one or two) substrates 11 to be treated, indicated by f1 (mm) and f2 (mm) in Fig. 2a. Thus, the total dielectric thickness of the dielectric barrier in the treatment space 5 between the at least two opposing electrodes (2, 3) equals d = d1+f1+f2+d2.

In the further embodiment shown in Fig. 2b, both d1 and d2 are 0 and the only dielectric material forming the dielectric barrier is a substrate 6, 7 itself in contact with the respective electrode 2, 3. In case of two substrates 6 and 7, the total dielectric thickness in this case is d = f1 + f2. In still another embodiment both d1 and d2 are 0 and only one substrate 7 is used. In this embodiment the total dielectric thickness equals f2, so d = f2. Also in this embodiment in which electrode 2 is not covered with a dielectric material it is possible to obtain a stable atmospheric glow discharge plasma in the treatment space 5.

In the embodiment shown in Fig. 5 and described above the electrodes 2, 3, are provided with a dielectric formed by the three substrates 6, 7, 11. In this particular case as shown the total dielectric thickness of the dielectric barrier in the treatment space 5 between the at least two opposing electrodes 2, 3 equals d = f1+f2+f3, where fi is the thickness of the i-th substrate.

The gap distance g as shown in Fig. 2a and 2b indicates the (smallest) gap between the electrodes 2, 3 where an atmospheric pressure glow discharge plasma can exist in operation, also called the free inter-electrode space. The total dielectric distance d thus depends on whether one substrate 6 is treated or two substrates 6, 7, or even three substrates 6, 7, 11 simultaneously and of the thickness and material of the substrates.

The dimensions of the electrodes 2, 3, dielectric barrier layers 2a, 3a, and gap g between the electrodes 2, 3 and the total dielectric distance d which is the total dielectric thickness of the dielectric barrier are controlled in a further embodiment, such that the product of gap distance and the total dielectric distance is arranged to be less than or equal to 1.0 mm$^2$ or even more preferred less than 0.5 mm$^2$. This is described in more detail in the published WO2009104957 of the applicant, which is herein incorporated by reference.

In the embodiments described above, the power supply 4 can be a power supply providing a wide range of frequencies. For example, it can provide a low frequency (f = 10-500 kHz) electrical signal during the on-time. It can also provide a high frequency electrical signal for example f = 450 kHz up to 30 MHz. Also other frequencies can be provided like from 450 kHz to 1 MHz or from 1 to 20 MHz and the like. The on-time may vary from very short, e.g. 20 $\mu$s, to short, e.g. 500 $\mu$s or as long as 2 minutes or even continuous. The on-time effectively results in a pulse train having a series of sine wave periods at the operating frequency, with a total duration of the on-time. According to the invention good results have been obtained using a duty cycle of 40% up to 100%.

Very good results can now be obtained by using an atmospheric pressure glow discharge (APG) plasma. Until recently these plasma's suffered from bad stability, but using the stabilization circuits as described in e.g. US-6774569, EP-A-1383359, EP-A-1547123 and EP-A-1626613 (which are incorporated herein by reference), very stable APG plasmas can be obtained. In general, these plasmas are stabilized by a stabilization circuit 21 (see description of Fig. 1) counteracting local instabilities in the plasma. Using the stabilization circuit 21 in combination with the AC power source 20 in the power supply 4 for the plasma generating apparatus 10 results in a controlled and stable plasma, without streamers, filamentary discharges or other imperfections.

Although oxygen as a reactive gas has a many advantages in for example surface modification uses or in uses where oxidative processes occur, other reactive gases might be used also, such as hydrogen, carbon dioxide, ammonia, oxides of nitrogen, and the like.

In the present invention, one or more carrier gasses are used chosen from the group comprising argon, nitrogen, or a combination of both. However, also other inert gasses (e.g. helium or argon) or combinations of inert gasses may be used.

In an embodiment the gas composition in the treatment space 5 comprises nitrogen in the range 79 to 99.9% and oxygen in the range of 0.1 to 21% vol.%, e,g, 95 to 99.9% and oxygen in the range of 0.1 to 5 vol.%. Oxygen concentrations higher than 21 vol.% may result in damage to the porous substrate 11.

In a further embodiment, the substrate 11 is heated during the plasma treatment by e.g. heating the electrodes 2, 3. The temperature of the heated electrodes 2, 3 (and thus the substrate 6, 7, 11) is typically between 20 and 150°C. Examples of such heating embodiments may be found in WO2008147184 from the same applicant, which is herein incorporated by reference. Other heating implementations, direct or indirect may be contemplated in further embodiments.

After the plasma treatment according to the present invention, the porous substrate 11 is volumetrically compatibilized (i.e. uniformly throughout the substrate and not only the top surface of the substrate), which is thought to be the result of volumetric hydrophylization of the micro-pores by oxidation and production of OH-groups as well as to uniform enlargement of the pores of the micro-porous substrate 11 by the plasma treatment.

After the plasma treatment step described above the activated porous substrate 11 is immersed in or impregnated with the ion exchange material, in order to obtain the actual ion exchange membrane. The impregnation step is done via techniques known as such in the art. Various options are available for applying the ion exchange solution components to the plasma treated porous substrates 11 which may include e.g. dip, spray, bar coating steps etc.

After the impregnation the resulting membranes were radiation cured using UV-light to obtain the final membrane ready for use.

Examples 1 to 5 and Reference Examples RE1 to RE3, RE8 and RE9

As a porous substrate 11 two grades of Solupor™ materials were tested.

As substrates 6 and 7 PET foil type Astera X063.004 from Agfa was used with a thickness of 63$\mu$m.

P1: Solupor™ 10P05A: porosity 83% /thickness 60$\mu$m /mean pore size is 0.5$\mu$m.

P2: Solupor™ 14P01E: porosity 40% /thickness 25$\mu$m /mean pore size is 0.1 $\mu$m.

Both porous substrates 11 (P1, P2) were separately treated on top of a supporting carrier PET foil 7 using an atmospheric pressure glow discharge plasma apparatus as shown in Fig. 5 having a treatment width of 150 mm and a gaseous gap of 0.5 mm at a controlled electrode temperature of 30°C at a web speed of 1 m/min. The substrate, gas composition and the power density was varied according to the Table 1 shown below. The plasma treated substrate on the receiving roll 24 was unwound and separated into two separated substrates 7 and 11.

Table 1

| Example | Porous substrate | gas composition and flows [slm] | excitation (overall power/pulsing) | Specific energy [J/cm$^2$] |
|---|---|---|---|---|
| RE1 | P1 | Ar 10 slm | 200 W, CW@ | 7.9 |
| RE2 | P2 | Ar/O$_2$ 10/1.0 slm | 200 W, CW@ | 7.9 |
| RE3 | P1 | Ar/O$_2$ 10/1.0 slm | 200 W, CW@ | 5.6 |
| 1 | P1 | N$_2$/O$_2$ 15/1.0 slm | 300 W (pulsed, 50% DC\$) | 12 |
| 2 | P1 | N$_2$/O$_2$ 15/0.1 slm | 600 W (pulsed, 90% DC\$) | 23.7 |
| 3 | P1 | N$_2$/O$_2$ 15/0.1 slm | 300 W (pulsed, 50% DC\$) | 12 |
| 4 | P1 | N$_2$/O$_2$ 15/0.05 slm | 300 W (pulsed, 50% DC\$) | 12 |
| 5 | P2 | N$_2$/O$_2$ 15/0.05 slm | 300 W (pulsed, 50% DC\$) | 12 |
| RE8 | P1 | N$_2$ 15 slm | 600 W (pulsed, 90% DC\$) | 23.7 |
| RE9 | P1 | N$_2$/O$_2$ 15/4.0 slm | 300 W (pulsed, 50% DC\$) | 12 |
| DC\$ means duty cycle<br>CW@ means continuous wave<br>RE means Reference Example<br>Note: Table 1 lists Examples 1 to 5 and Reference Examples 8 and 9 which were treated in the atmospheric pressure glow discharge plasma as shown in Fig.5. Reference Examples RE4 to RE7 are described below. | | | | |

Reference Examples RE4 and RE5 (Corona Treatment)

The two porous substrates P1, P2 (Solupor™ 10P05A and 14P01E) used above were Corona treated in air using a Softal™ corona VTG250 apparatus at a specific energy of 16 J/cm$^2$ using ceramic electrodes coupled to a Softal™ VTG3005 generator.

Reference Examples RE6 and RE7

The same porous substrates as above however untreated (in plasma or corona environment) were used as reference samples 4 and 5.

Before the impregnation step, all five Examples and nine Reference Examples were checked by a Jeol JSM-6330F Field Emission Scanning Electron Microscope (SEM) SE detector/5kV Accelerating Voltage/15 mm Working Distance/Aperture 2/Pt-coating, 10 nm thickness/enlargement 2000x).

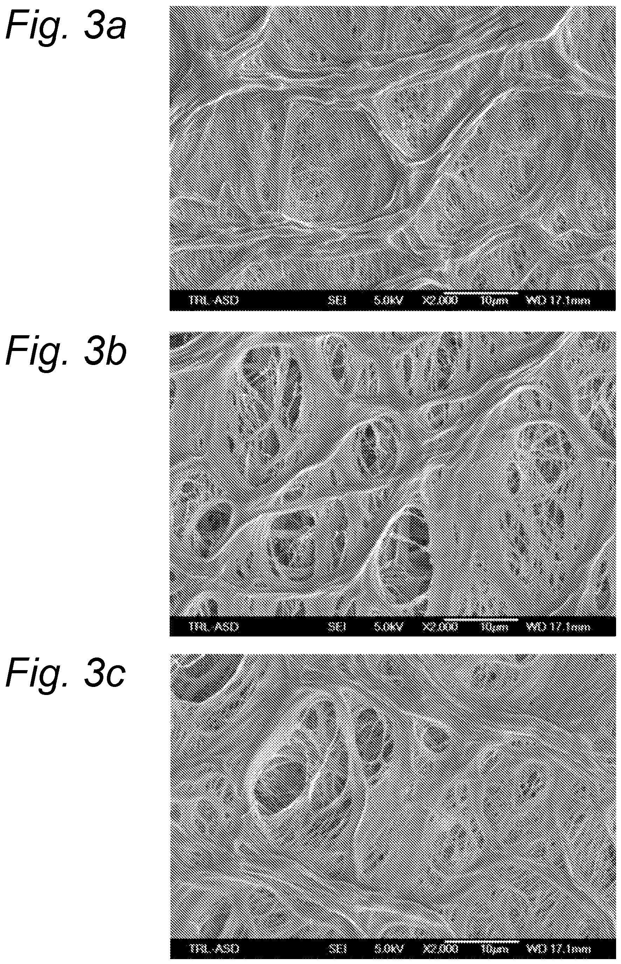

Fig. 3a is showing the reference SEM image of the top-side Reference Example 6 and Fig. 3b and 3c show respectively top- and bottom SEM image of inventive Example 1.

Impregnation samples 1-14

All fourteen samples of above (i.e. Examples 1 to 5 and Reference Examples RE1 to RE9) were impregnated with two kinds of recipes (one C1 recipe for making a cationic membrane and one A1 recipe for making an an-ionic membrane) resulting in 28 samples by a dip-coating of all 14 samples in a bath containing the C1 or A1 recipe-solutions.

Recipe solution C1 and A1 were prepared by mixing the ingredients expressed as wt.% as shown in Table 2 and 3.

Table 2 - Recipe C1 (for a cationic membrane)

| Ingredient | wt.% |
|---|---|
| ATMAC | 27.6 |
| MBA | 20.6 |
| Water | 21.3 |
| IPA | 8.9 |
| LiNO3 | 21.1 |
| MEHQ | 0.05 |
| Darocur™ 1173 | 0.45 |

Table 3 - Recipe A1 (for an anionic membrane)

| Ingredient | wt.% |
|---|---|
| AMPS | 50.3 |
| MBA | 12.0 |
| Water | 28.4 |
| IPA | 8.3 |
| Genorad™ 16 | 0.5 |
| Darocur™ 1173 | 0.5 |

AMPS      is 2-Acryloylamido-2-methylpropanesulfonic acid from Hang-Zhou (China) (a curable compound having one ethylenically unsaturated group), having a molecular weight of 207.2.

MBA      is N,N'-methylene bisacrylamide from Sigma Aldrich (a curable compound comprising at least two (meth)acrylic groups and being free from quaternary ammonium groups), having a molecular weight of 154.2.

ATMAC      is 3-acrylamidopropyl-trimethylammonium chloride from Kohjin (a curable compound having one ethylenically unsaturated group), having a molecular weight of 206.7.

IPA      is 2-propanol from Shell (a solvent).

MEHQ      is hydroquinone mono methyl ether (a polymerization inhibitor).

$LiNO_3$      is lithium nitrate.

IPA      is 2-propanol from Shell.

Genorad™ 16      is a polymerization inhibitor.
Darocur™ 1173      is a photo initiator.

After impregnation the samples were radiation cured using a Light Hammer LH6 from Fusion UV Systems fitted with a D-bulb working at 100% intensity with a speed of 30 m/min (single pass). The exposure time was 0.47 seconds.

After the impregnation with Recipe A1 and C1, the samples were inspected visually and by SEM images off cross-cuts of the membranes. Table 4 shows the results of these inspections.

Table 4

| | Damage | Impregnation (checked by SEM #) |
|---|---|---|
| RE1 | no | no |
| RE2 | no/matte surface | no |
| RE3 | no/matte surface | no |
| Example 1 | no | yes |
| Example 2 | no | yes |
| Example 3 | no | yes |
| Example 4 | no | yes |
| Example 5 | no | yes |
| RE4 | no | no |
| RE5 | no | no |
| RE6 | - | no |
| RE7 | - | no |
| RE8 (0% oxygen) | no | no |
| RE9 (>21 vol.% oxygen) | yes | yes |
| #: the impregnation evaluation was performed using a Jeol JSM-6330F Field Emission Scanning Electron Microscope (SEM) SE detector/5kV Accelerating Voltage/15 mm Working Distance/Aperture 2/Pt-coating, 10 nm thickness/enlargement 1000x) | | |

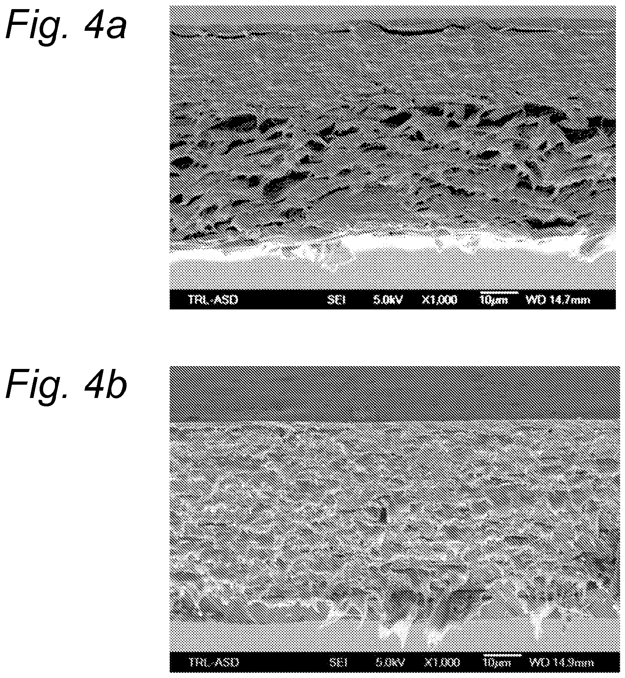

Fig. 4a shows a scanning electron microscope image of a cross section of a comparative membrane prepared using a corona plasma treatment (Reference Example RE4) and Fig. 4b shows a membrane according to an embodiment of the present invention (Example 1), in each case using Recipe A1.

From the Examples 1-5 shown in Tables 1 and 4, it can be inferred that the compatabilitization due to uniform and volumetric impregnation is the result of the plasma treatment according to the present invention. In particular, Reference Examples RE1 and RE8 lack oxygen in the gas composition. Reference Example RE9 shows that more than 21 vol.% oxygen in the gas composition damaged the membrane. Furthermore, the specific energy of the atmospheric pressure glow discharge plasma in the treatment space was rather low for Reference Examples RE2-3, i.e. less than 10 J/cm$^2$. Reference Examples RE6 and RE7 indicate that the corona treatment does not allow for proper impregnation of the porous substrate, hence further proving the advantages of the present invention.

The present invention embodiments have been described above with reference to a number of exemplary embodiments as shown in and described with reference to the drawings. Modifications and alternative implementations of some parts or elements are possible, and are included in the scope of protection as defined in the appended claims.

**Claims**

**1.** A method of treating a substrate, comprising:

    providing a treatment space between at least two opposing electrodes, filling the treatment space with a gas composition, placing the substrate, which is a porous substrate, in the treatment space,
    generating an atmospheric pressure glow discharge plasma between the at least two opposing electrodes, and

subjecting the porous substrate to the atmospheric pressure glow discharge plasma, thereby creating micro-pores uniformly throughout the porous substrate,

wherein the treatment space comprises oxygen in the range of 0.1 to 21% vol.%, **characterised in that** the atmospheric pressure glow discharge plasma in the treatment space has a specific energy of 10 J/cm$^2$ or higher, and **in that** the method is performed with a duty cycle of 40% to 100%.

2. A method according to claim 1 which is powered by a power supply comprises an AC power source connected to a stabilisation circuit.

3. A method according to claim 1 or 2 which is performed using pulsed power.

4. A method according to claim 1, 2 or 3, wherein the porous substrate comprises a polymer support.

5. A method according to any one of claims 1-4, further comprising impregnating the substrate with ion exchange material.

6. A method according to any one of claims 1-5, further comprising radiation curing of the porous substrate.

7. A method according to any one of claims 1-6, further comprising heating the porous substrate to a temperature between 20 and 150°C.

8. A method according to any one of claims 1-7, wherein the treatment space comprises nitrogen in the range 79 to 99.9%.

9. A method according to claim 8, wherein the treatment space comprises nitrogen in the range 95 to 99.9%.

10. A method according to any one of claims 1-9, wherein the micro-pores have an average diameter of between 0.1$\mu$m and 10$\mu$m.

11. A method according to any one of claims 1-10, wherein the porous substrate has a porosity between 25 and 95%.

12. A method according to any one of claims 1-11, wherein the substrate has a thickness of 60 $\mu$m or less.

13. A method according to any one of claims 1-12, wherein a carrier substrate is positioned in contact the electrodes.

14. A method according to any one of claims 1-13, wherein the treatment space comprises oxygen in the range 0.1 to 5 vol. %.

15. Use of a membrane comprising a substrate obtainable by a method according to any one of the preceding claims for energy storage, energy conversion, electro-dialysis, separation of ionic species, nano-filtration or ultra-filtration.


**Patentansprüche**

1. Verfahren zur Behandlung eines Substrats, umfassend:

Bereitstellen eines Behandlungsraums zwischen mindestens zwei gegenüberliegenden Elektroden,
Füllen des Behandlungsraums mit einer Gaszusammensetzung,
Platzieren des Substrats, welches ein poröses Substrat ist, in dem Behandlungsraum,
Generieren eines Glimmentladungsplasmas bei atmosphärischem Druck zwischen den mindestens zwei gegenüberliegenden Elektroden, und
Aussetzen des porösen Substrats dem Glimmentladungsplasma bei atmosphärischem Druck, wodurch gleichförmig über das poröse Substrat verteilte Mikroporen erzeugt werden,
wobei der Behandlungsraum Sauerstoff im Bereich von 0,1 bis 21 Vol.% umfasst, **dadurch gekennzeichnet, dass** das Glimmentladungsplasma bei atmosphärischem Druck in dem Behandlungsraum eine spezifische Energie von 10 J/cm$^2$ oder höher aufweist, und dass das Verfahren mit einem Arbeitszyklus von 40 % bis 100 % durchgeführt wird.

**2.** Verfahren nach Anspruch 1, das von einer Stromversorgung angetrieben wird, die eine Wechselspannungs-(AC)-Stromversorgung umfasst, die mit einer Stabilisierungsschaltung verbunden ist.

**3.** Verfahren nach Anspruch 1 oder 2, die mit gepulster Leistung durchgeführt wird.

**4.** Verfahren nach Anspruch 1, 2 oder 3, wobei das poröse Substrat einen Polymerträger umfasst.

**5.** Verfahren nach einem der Ansprüche 1 bis 4, ferner umfassend Imprägnieren des Substrats mit Ionenaustauschmaterial.

**6.** Verfahren nach einem der Ansprüche 1 bis 5, ferner umfassend Strahlungshärten des porösen Substrats.

**7.** Verfahren nach einem der Ansprüche 1 bis 6, ferner umfassend Heizen des porösen Substrats auf eine Temperatur zwischen 20 und 150 °C.

**8.** Verfahren nach einem der Ansprüche 1 bis 7, wobei der Behandlungsraum Stickstoff im Bereich von 79 bis 99,9 % umfasst.

**9.** Verfahren nach Anspruch 8, wobei der Behandlungsraum Stickstoff im Bereich von 95 bis 99,9 % umfasst.

**10.** Verfahren nach einem der Ansprüche 1 bis 9, wobei die Mikroporen einen durchschnittlichen Durchmesser zwischen 0,1 $\mu$m und 10 $\mu$m aufweisen.

**11.** Verfahren nach einem der Ansprüche 1 bis 10, wobei das poröse Substrat eine Porosität zwischen 25 und 95 % aufweist.

**12.** Verfahren nach einem der Ansprüche 1 bis 11, wobei das Substrat eine Dicke von 60 $\mu$m oder weniger aufweist.

**13.** Verfahren nach einem der Ansprüche 1 bis 12, wobei ein Trägersubstrat in Kontakt mit den Elektroden positioniert wird.

**14.** Verfahren nach einem der Ansprüche 1 bis 13, wobei der Behandlungsraum Sauerstoff im Bereich von 0,1 bis 5 Vol.% umfasst.

**15.** Verwendung einer Membran, die ein Substrat umfasst, welches gemäß einem Verfahren nach einem der vorhergehenden Ansprüche erhältlich ist, zur Energiespeicherung, Energieumwandlung, Elektrodialyse, Trennung von ionischen Spezies, Nanofiltration oder Ultrafiltration.

**Revendications**

**1.** Procédé de traitement d'un substrat, comprenant :

l'aménagement d'un espace de traitement entre au moins deux électrodes opposées,
le remplissage de l'espace de traitement avec une composition de gaz,
la mise en place du substrat, qui est un substrat poreux, dans l'espace de traitement,
la production d'un plasma de décharge luminescente à pression atmosphérique entre les au moins deux électrodes opposées et
le fait de soumettre le substrat poreux au plasma de décharge luminescente à pression atmosphérique, ce qui crée ainsi des micropores de manière uniforme dans tout le substrat poreux,
dans lequel l'espace de traitement comprend de l'oxygène dans la plage de 0,1 à 21 % en volume,
**caractérisé en ce que** le plasma de décharge luminescente à pression atmosphérique dans l'espace de traitement a une énergie spécifique supérieure ou égale à 10 J/cm$^2$ et **en ce que** le procédé est mis en oeuvre avec un facteur d'utilisation de 40 % à 100 %.

**2.** Procédé selon la revendication 1 qui est alimenté en énergie par une alimentation électrique comprenant une source de courant alternatif connectée à un circuit de stabilisation.

**3.** Procédé selon la revendication 1 ou 2 qui est mis en oeuvre à l'aide d'une énergie puisée.

**4.** Procédé selon la revendication 1, 2 ou 3, dans lequel le substrat poreux comprend un support en polymère.

**5.** Procédé selon l'une quelconque des revendications 1-4, comprenant en outre l'imprégnation du substrat avec une matière échangeuse d'ions.

**6.** Procédé selon l'une quelconque des revendications 1-5, comprenant en outre le durcissement par rayonnement du substrat poreux.

**7.** Procédé selon l'une quelconque des revendications 1-6, comprenant en outre le chauffage du substrat poreux à une température comprise entre 20 et 150 °C.

**8.** Procédé selon l'une quelconque des revendications 1-7, dans lequel l'espace de traitement comprend de l'azote dans la plage de 79 à 99,9 %.

**9.** Procédé selon la revendication 8, dans lequel l'espace de traitement comprend de l'azote dans la plage de 95 à 99,9 %.

**10.** Procédé selon l'une quelconque des revendications 1-9, dans lequel les micropores ont un diamètre moyen compris entre 0,1 $\mu$m et 10 $\mu$m.

**11.** Procédé selon l'une quelconque des revendications 1-10, dans lequel le substrat poreux a une porosité comprise entre 25 et 95 %.

**12.** Procédé selon l'une quelconque des revendications 1-11, dans lequel le substrat a une épaisseur inférieure ou égale à 60 $\mu$m.

**13.** Procédé selon l'une quelconque des revendications 1-12, dans lequel un substrat porteur est disposé en contact avec les électrodes.

**14.** Procédé selon l'une quelconque des revendications 1-13, dans lequel l'espace de traitement comprend de l'oxygène dans la plage de 0,1 à 5 % en volume.

**15.** Utilisation d'une membrane comprenant un substrat pouvant être obtenu par un procédé selon l'une quelconque des revendications précédentes pour le stockage d'énergie, la conversion d'énergie, l'électrodialyse, la séparation d'espèces ioniques, la nanofiltration ou l'ultrafiltration.

## Fig 1

## Fig 2a

## Fig 2b

## Fig. 3a

## Fig. 3b

## Fig. 3c

*Fig. 4a*

*Fig. 4b*

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002132107 A1
- EP 504954 A
- EP 0504954 A
- WO 2009104957 A
- US 6774569 B
- EP 1383359 A
- EP 1547123 A
- EP 1626613 A
- WO 2008147184 A